# EUROPÄISCHE PATENTSCHRIFT

(11) **EP 4 025 726 B1**
(45) Veröffentlichungstag und Bekanntmachung des Hinweises auf die Patenterteilung: **12.07.2023**
(21) Anmeldenummer: 20751546.1
(22) Anmeldetag: 05.08.2020
(51) Int. Cl.: C30B 15/30, C30B 29/06, C30B 30/04

(54) **VERFAHREN ZUR HERSTELLUNG VON HALBLEITERSCHEIBEN AUS EINKRISTALLINEM SILIZIUM**
METHOD FOR PRODUCING SEMICONDUCTOR WAFERS FROM MONOCRYSTALLINE SILICON
PROCÉDÉ DE PRODUCTION DE TRANCHES DE SEMI-CONDUCTEUR À PARTIR DE SILICIUM MONOCRISTALLIN

(30) Priorität: 02.09.2019 DE 102019213236
(43) Veröffentlichungstag der Anmeldung: 13.07.2022
(73) Patentinhaber: Siltronic AG, 81677 München (DE)
(72) Erfinder: HEUWIESER, Walter, 84533 Stammham (DE); MANGELBERGER, Karl, 5122 Ach (AT); VETTERHÖFFER, Jürgen, 84489 Burghausen (DE)
(74) Vertreter: Staudacher, Wolfgang
(86) Internationale Anmeldenummer: PCT/EP2020/072014
(87) Internationale Veröffentlichungsnummer: WO 2021/043523

(56) Entgegenhaltungen:
- DE-A1-102010 028 924
- DE-T5-112014 002 183
- JP-A- H0 692 775
- US-A1- 2009 235 861
- US-A1- 2009 249 996

## Beschreibung

Gegenstand der Erfindung ist ein Verfahren zur Herstellung von Halbleiterscheiben aus einkristallinem Silizium.

Halbleiterscheiben aus einkristallinem Silizium werden in industriellem Maßstab hergestellt. Eine Vielzahl von solchen Halbleiterscheiben entsteht beim Abtrennen der Halbleiterscheiben vom zylindrischen Abschnitt eines Einkristalls, der aus einer Schmelze gezogen wurde, die in einem Tiegel enthalten war. Dieses Verfahren zur Herstellung des Einkristalls ist auch unter der Bezeichnung CZ-Methode bekannt. Die hergestellten Halbleiterscheiben werden typischerweise zu elektronischen Bauelementen weiterverarbeitet.

### Stand der Technik / Problem

Gewisse Anwendungen insbesondere auf dem Gebiet der Leistungselektronik erfordern Halbleiterscheiben mit vergleichsweise großem Durchmesser, die interstitiellen Sauerstoff (nachfolgend vereinfachend zu Sauerstoff verkürzt) in vergleichsweise geringer Konzentration innerhalb vergleichsweise enger Grenzen enthalten. In dieser Beschreibung wird die Konzentration an Sauerstoff als vergleichsweise gering verstanden, wenn deren Wert nicht mehr als 5 × 10¹⁷ Atome/cm³ beträgt und er gemäß new ASTM bestimmt wird.

In DE 10 2010 028 924 A1 ist beschrieben, dass die Konzentration an Sauerstoff im Einkristall durch das Einwirken eines horizontalen Magnetfelds auf die Schmelze und durch das Herabsetzen der Drehgeschwindigkeit des Tiegels reduziert werden kann.

Des Weiteren wird in JP 9 175 895 A2 unter anderem empfohlen, die Drehgeschwindigkeit des Tiegels ausgehend von einer Grund-Drehgeschwindigkeit periodisch zu steigern und die Grund-Drehgeschwindigkeit und die Amplitude der Steigerung in Abhängigkeit der Länge des gewachsenen Einkristalls zu erhöhen.

Es wurde nun festgestellt, dass bei Berücksichtigung solcher Lehren es zwar gelingt, die Konzentration an Sauerstoff im Einkristall auf einen vergleichsweise niedrigen Wert zu senken, die Konzentration über die Länge des Einkristalls aber vergleichsweise stark variiert.

JPH0692775A zeigt ein Verfahren zur Herstellung eines Siliziumeinkristalls umfassend das periodische Ändern der Drehrichtung des Tiegels.

Aufgabe der Erfindung ist deshalb, axiale Schwankungen der Sauerstoff-Konzentration abzumildern.

Die Aufgabe der Erfindung wird gelöst durch ein Verfahren zur Herstellung von Halbleiterscheiben aus einkristallinem Silizium, umfassend
das Ziehen eines zylindrischen Abschnitts eines Einkristalls aus Silizium aus einer Schmelze, die in einem Tiegel enthalten ist;
das Beaufschlagen der Schmelze mit einem horizontalen Magnetfeld;
das Drehen des Tiegels mit einer Drehgeschwindigkeit und in eine Drehrichtung während des Ziehens des zylindrischen Abschnitts des Einkristalls; und
das Abtrennen der Halbleiterscheiben aus einkristallinem Silizium vom zylindrischen Abschnitt des Einkristalls, dadurch gekennzeichnet, dass
der Betrag der Drehgeschwindigkeit über die Zeit gemittelt weniger als 1 U/min beträgt und die Drehrichtung fortgesetzt gewechselt wird und eine Amplitude der Drehgeschwindigkeit vor und nach dem Wechsel der Drehrichtung nicht weniger als 0,5 U/min und nicht mehr als 3,0 U/min beträgt.

Durch Anwendung der Erfindung lassen sich axiale Schwankungen der Konzentration von Sauerstoff im zylindrischen Abschnitt des Einkristalls, ausgedrückt als Differenz von größter Konzentration und kleinster Konzentration, mehr als halbieren.

Die Erfindung lässt sich unabhängig vom Durchmesser des zylindrischen Abschnitts des Einkristalls nutzen. Die Konzentration an Sauerstoff beträgt im zylindrischen Abschnitt des Einkristalls nicht mehr als 5 × 10¹⁷ Atome/cm³. Vorzugsweise werden mit dem erfindungsgemäßen Verfahren Halbleiterscheiben hergestellt, deren Durchmesser mindestens 200 mm, besonders bevorzugt mindestens 300 mm beträgt.

Damit die Aufgabe gelöst wird, muss die Drehgeschwindigkeit des Tiegels im zeitlichen Mittel (mittlere Drehgeschwindigkeit) weniger als 1 U/min, vorzugsweise nicht mehr als 0,7 U/min betragen. Die Richtung der mittleren Drehgeschwindigkeit des Tiegels kann mit der Richtung der Drehgeschwindigkeit des Einkristalls übereinstimmen oder ihr entgegengesetzt sein. Bevorzugt ist, dass die Richtungen übereinstimmen. Darüber hinaus muss die Drehrichtung des Tiegels fortgesetzt gewechselt werden, vorzugsweise periodisch. Die Länge einer Periode beträgt vorzugsweise 10 bis 100 s. Vor und nach dem Wechsel der Drehrichtung beträgt die Amplitude der Drehgeschwindigkeit nicht weniger als 0,5 U/min und nicht mehr als 3,0 U/min. Ein Überschreiten der Amplitude über die obere Grenze ist nicht empfehlenswert, es sei denn, es wird im Einkristall eine Konzentration von Sauerstoff von mehr als 5 × 10¹⁷ Atome/cm³ angestrebt.

Das horizontale Magnetfeld hat im Bereich der Phasengrenze zwischen dem wachsenden Einkristall und der Schmelze eine Intensität von vorzugsweise nicht weniger als 0,2 T und nicht mehr 0,4 T.

Die Erfindung wird nachfolgend unter Bezugnahme auf Zeichnungen weiter beschrieben.

### Kurzbeschreibung der Figuren

**Fig. 1** zeigt schematisch den zeitlichen Verlauf der Drehgeschwindigkeit des Tiegels über eine Periode.
**Fig. 2** zeigt die Konzentration von Sauerstoff in zwei Gruppen von Einkristallen aus Silizium in Abhängigkeit der axialen Position im zylindrischen Abschnitt der Einkristalle.

### Liste der verwendeten Bezugszeichen

### 1 Zeitpunkt beim Wechsel der Drehrichtung

### Detaillierte Beschreibung erfindungsgemäßer Ausführungsbeispiele

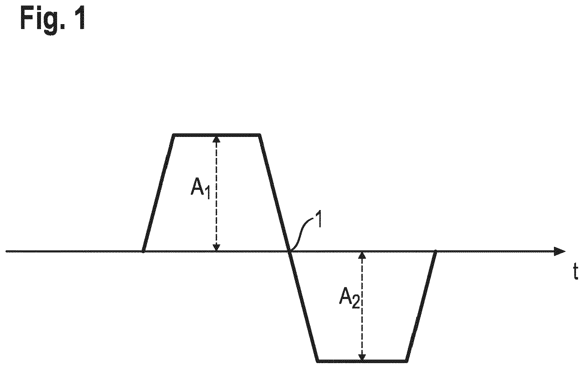

Wie in Fig. 1 dargestellt wird er Tiegel während einer Periode in eine Drehrichtung bis zu einer Amplitude A₁ beschleunigt und wieder abgebremst und anschließend zum Zeitpunkt 1 des Wechsels der Drehrichtung in entgegengesetzte Drehrichtung bis zu einer Amplitude A₂ beschleunigt und wieder abgebremst. Die Amplituden A₁ und A₂ unterscheiden sich im Betrag, so dass eine mittlere Drehgeschwindigkeit in eine der Drehrichtungen resultiert.

Beispiel:
Es wurden zwei Gruppen von Einkristallen aus Silizium mit einem Durchmesser von 300 mm nach dem CZ-Verfahren gezogen und vom jeweiligen zylindrischen Abschnitt der Einkristalle Halbleiterscheiben abgetrennt. Eine erste Gruppe der Einkristalle wurde erfindungsgemäß gezogen, also insbesondere indem während des Ziehens des zylindrischen Abschnitts des Einkristalls die Drehrichtung des Tiegels mit einer Periodendauer von 40 s und einer Amplitude von nicht mehr als 1,1 U/min gewechselt wurde. Im Unterschied dazu wurde die andere Gruppe von Einkristallen unter sonst identischen Bedingungen ohne Wechsel der Drehrichtung des Tiegels gezogen. Für beide Gruppen betrug die mittlere Drehgeschwindigkeit des Tiegels 0,6 U/min.

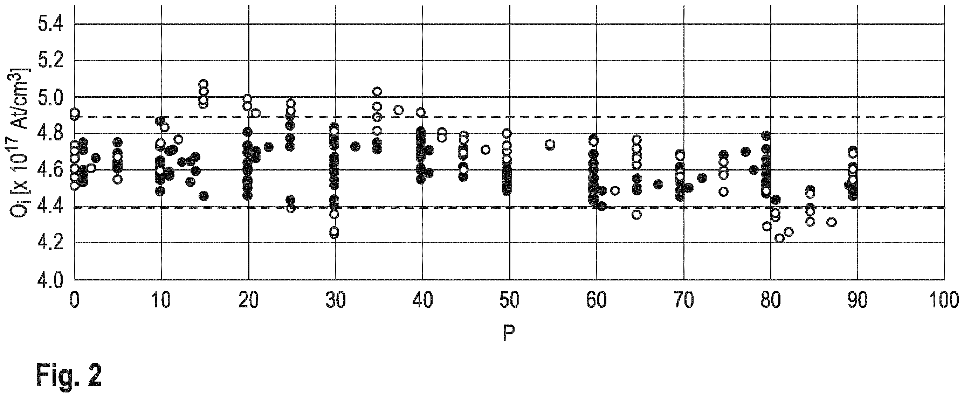

Die Bestimmung der Sauerstoff-Konzentrationen in Abhängigkeit einer relativen axialen Position P im zylindrischen Abschnitt der Einkristalle ergab das in Fig.2 dargestellte Ergebnis. Demnach kann bei Anwendung des erfindungsgemäßen Verfahrens erwartet werden, dass die Sauerstoff-Konzentration in einem vergleichsweise engen Korridor bleibt. Im vorliegenden Fall lagen alle Datenpunkte (gefüllte Kreise), die erfindungsgemäß gezogenen Einkristallen zugeordnet waren, innerhalb des durch gestrichelte Linien eingegrenzten Korridors mit einer Sauerstoff-Konzentration von 4,4 × 10¹⁷ Atomen/cm³ bis ungefähr 4,9 × 10¹⁷ Atome/cm³.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren.

## Patentansprüche

1. Verfahren zur Herstellung von Halbleiterscheiben aus einkristallinem Silizium, umfassend
das Ziehen eines zylindrischen Abschnitts eines Einkristalls aus Silizium aus einer Schmelze, die in einem Tiegel enthalten ist, wobei die Konzentration an Sauerstoff im zylindrischen Abschnitt nicht mehr als 5 × 10¹⁷ Atome/cm³ beträgt;
das Beaufschlagen der Schmelze mit einem horizontalen Magnetfeld;
das Drehen des Tiegels mit einer Drehgeschwindigkeit und in eine Drehrichtung während des Ziehens des zylindrischen Abschnitts des Einkristalls; und
das Abtrennen der Halbleiterscheiben aus einkristallinem Silizium vom zylindrischen Abschnitt des Einkristalls, **dadurch gekennzeichnet, dass**
der Betrag der Drehgeschwindigkeit über die Zeit gemittelt weniger als 1 U/min beträgt und die Drehrichtung fortgesetzt gewechselt wird und eine Amplitude der Drehgeschwindigkeit vor und nach dem Wechsel der Drehrichtung nicht weniger als 0,5 U/min und nicht mehr als 3,0 U/min beträgt.

2. Verfahren nach Anspruch 1, **dadurch gekennzeichnet, dass** die Drehrichtung periodisch gewechselt wird mit einer Länge der Periode von 10 bis 100 s.

3. Verfahren nach Anspruch 1 oder Anspruch 2, **dadurch gekennzeichnet, dass** der Betrag der Drehgeschwindigkeit über die Zeit gemittelt nicht mehr als 0,7 U/min beträgt.

## Claims

1. A process for the production of semiconductor wafers from monocrystalline silicon, comprising
pulling a cylindrical portion of a single crystal of silicon from a melt contained in a crucible, wherein the concentration of oxygen in the cylindrical portion is not more than 5 × 1017 atoms/cm3; applying a horizontal magnetic field to the melt; rotating the crucible at a rotational speed and in a rotational direction while pulling the cylindrical portion of the single crystal; and separating the semiconductor wafers of single crystal silicon from the cylindrical portion of the single crystal, **characterized in that** the amount of the rotation speed averaged over time is less than 1 rpm and the rotation direction is changed continuously and an amplitude of the rotation speed before and after the change of the rotation direction is not less than 0.5 rpm and not more than 3.0 rpm.

2. Method according to claim 1, **characterized in that** the direction of rotation is changed periodically with a length of the period of 10 to 100 s.

3. Method according to claim 1 or claim 2, **characterized in that** the amount of rotational speed averaged over time is not more than 0.7 rpm.

## Revendications

1. Procédé de fabrication de plaquettes semi-conductrices en silicium monocristallin, comprenant
le tirage d'une partie cylindrique d'un monocristal de silicium à partir d'une masse fondue contenue dans un creuset, la concentration d'oxygène dans la partie cylindrique n'étant pas supérieure à 5 × 1017 atomes/cm3 ; l'application d'un champ magnétique horizontal à la masse fondue ; la rotation du creuset à une vitesse de rotation et dans un sens de rotation pendant le tirage de la partie cylindrique du monocristal ; et la séparation des plaquettes semi-conductrices de silicium monocristallin de la partie cylindrique du monocristal,
**caractérisé en ce que** la valeur de la vitesse de rotation, moyennée dans le temps, est inférieure à 1 tr/min et le sens de rotation est continuellement changé, et une amplitude de la vitesse de rotation avant et après le changement du sens de rotation n'est pas inférieure à 0,5 tr/min et pas supérieure à 3,0 tr/min.

2. Procédé selon la revendication 1, **caractérisé en ce que** le sens de rotation est changé périodiquement avec une longueur de période de 10 à 100 s.

3. Procédé selon la revendication 1 ou la revendication 2, **caractérisé en ce que** la valeur de la vitesse de rotation, moyennée dans le temps, n'est pas supérieure à 0,7 tr/min.
